# FASCICULE DE BREVET EUROPEEN

(11) **EP 1 300 949 B1**
(45) Date de publication et mention de la délivrance du brevet: **14.07.2004**
(21) Numéro de dépôt: 01203763.6
(22) Date de dépôt: 05.10.2001
(51) Int. Cl.: H03L 7/08

(54) **Circuit compteur diviseur double mode à phase commutée ayant des moyens pour réduire la consommation**
Dual Modulus Zähler/Teiler mit Phasenauswahl mit Mitteln zur Reduzierung des Energieverbrauches
Dual modulus counter/divider with phase selection provided with means for power consumption reduction

(43) Date de publication de la demande: 09.04.2003
(73) Titulaire: ASULAB S.A., 2074 Marin (CH)
(72) Inventeur: Casagrande, Arnaud, 2523 Lignières (CH)
(74) Mandataire: Laurent, Jean

(56) Documents cités:
- US-A- 4 754 235
- CRANINCKX J ET AL: "A 1.75-GHZ/3-V DUAL-MODULUS DIVIDE-BY-128/129 PRESCALER IN 0.7-MUM CMOS" IEEE JOURNAL OF SOLID-STATE CIRCUITS, IEEE INC. NEW YORK, US, vol. 31, no. 7, 1 juillet 1996 (1996-07-01), pages 890-897, XP000632373 ISSN: 0018-9200

## Description

L'invention concerne un circuit compteur diviseur double mode à phase commutée ayant des moyens pour réduire la consommation. Le circuit compteur diviseur double mode fait partie d'un synthétiseur de fréquence. Ledit circuit divise la fréquence d'au moins un signal à haute fréquence par un facteur N dans un premier mode sélectionné et par un facteur N+M dans un second mode sélectionné. Il comprend plusieurs diviseurs par deux connectés en série du type asynchrone. Un des diviseurs par deux est du type maître-esclave pour recevoir deux signaux d'entrée en opposition de phase et fournir quatre signaux déphasés de 90° l'un par rapport à l'autre. Le circuit comprend également un bloc sélecteur de phase intercalé entre deux des diviseurs par deux pour recevoir les quatre signaux déphasés du premier diviseur maître-esclave et fournir un des quatre signaux déphasés sélectionné au second diviseur. Deux branches de sélection du bloc sélecteur reçoivent chacun deux des quatre signaux déphasés. Un élément de sélection du bloc sélecteur est relié à chaque branche pour fournir en sortie dudit bloc un des quatre signaux déphasés sélectionné dans une période de division déterminée en fonction du mode sélectionné. Pour la sélection des signaux déphasés, des premiers signaux de commande sont fournis par un bloc de commande aux deux branches, ainsi qu'à l'élément de sélection.

Les synthétiseurs de fréquence sont utilisés notamment dans des systèmes de communication sans fils ou, plus généralement, dans des systèmes de télécommunication afin de fournir des signaux à haute fréquence. Les signaux à haute fréquence sont susceptibles d'être utilisés par exemple pour des opérations de démodulation de signaux RF reçus.

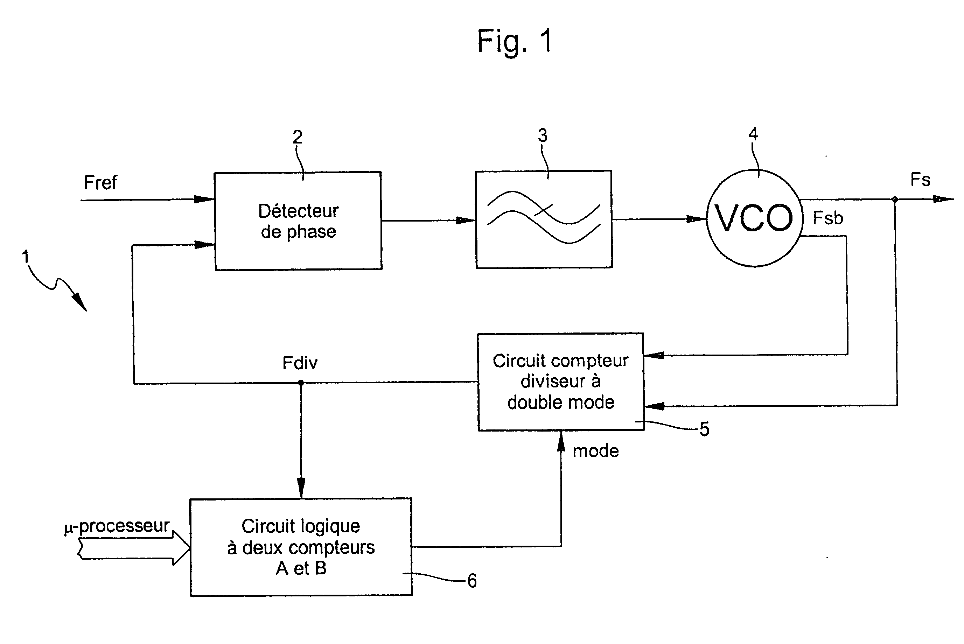

La figure 1 représente une forme de réalisation d'un synthétiseur de fréquence conventionnel avec un circuit compteur diviseur double mode. Ce synthétiseur comprend tout d'abord un oscillateur de référence, non représenté. Cet oscillateur fournit un signal de référence Fref à fréquence stable à un détecteur de phase et de fréquence 2. Ce détecteur reçoit également un signal à fréquence divisée Fdiv d'un circuit compteur diviseur double mode 5 afin de comparer le signal de référence et le signal à fréquence divisée. En fonction de la différence de phase et de fréquence des signaux Fref et Fdiv, le détecteur fournit un signal de comparaison à un filtre passe-bas 3 relié à un oscillateur commandé en tension 4 (VCO). Cet oscillateur commandé en tension reçoit un signal de commande en tension provenant du filtre passe-bas afin que cet oscillateur produise au moins un signal à haute fréquence dépendant de la comparaison entre les signaux Fref et Fdiv.

L'oscillateur commandé en tension peut être un oscillateur du type différentiel afin de fournir deux signaux à haute fréquence Fs et Fsb en opposition de phase au circuit compteur diviseur 5 dans une boucle à blocage de phase. Au moins un des signaux à haute fréquence Fs ou Fsb peut être ainsi utilisé pour des opérations de démodulation dans un récepteur de signaux radiofréquences par exemple.

Le circuit compteur diviseur double mode 5 a la faculté de permettre une division de fréquence selon un facteur de division dépendant d'un mode sélectionné. Pour ce faire, un circuit logique à deux compteurs A et B est généralement utilisé pour fournir une sélection de mode au circuit compteur diviseur. Ce circuit logique 6, bien connu dans ce domaine technique, est commandé par un microprocesseur et par le signal à fréquence divisée Fdiv. Les deux compteurs A et B sont en principe cadencés en synchronisme par un même signal d'horloge, mais le nombre compté par chaque compteur avant une remise à zéro est différent. Cela permet ainsi au circuit logique 6 de fournir un signal de mode au circuit compteur diviseur afin de changer de mode de division dans des périodes déterminées.

Plusieurs réalisations de circuits compteurs diviseurs du type double mode ont déjà été proposées, mais comme ces circuits doivent fonctionner à haute vitesse, ils sont plus difficiles à concevoir que de simples diviseurs de fréquence à rapport de division fixe. Une des difficultés est que la partie logique du circuit, pour obtenir une division de fréquence selon des premier et second facteurs de division, ralentit tout le circuit.

Un circuit compteur diviseur double mode conventionnel, devant fonctionner à haute vitesse, comprend une première partie de division synchrone, pour la sélection du facteur de division, et une seconde partie de division asynchrone. En général, la première partie de division synchrone est la seule partie fonctionnant à la plus haute fréquence. Ceci peut être un inconvénient, car plusieurs bascules de la première partie de division sont synchronisées par le même signal qui est un signal à haute fréquence, ce qui implique une forte consommation en courant.

Le brevet US 6,067,339 décrit un tel circuit compteur diviseur double mode. Le circuit permet d'opérer une division de fréquence selon deux facteurs de division en fonction d'un mode sélectionné. Par exemple selon le mode choisi, le facteur peut être égal à 64 ou à 65, ou également à 128 ou à 130. Ce circuit comprend plusieurs diviseurs par deux connectés en série, dont un bloc de diviseurs est synchrone pour opérer une division par 4 ou par 5, alors que les autres diviseurs sont du type asynchrone.

Ce bloc de diviseurs synchrones est agencé avec un certain nombre de portes logiques afin de permettre au circuit de diviser le signal à haute fréquence par un des deux facteurs de division sélectionné. Le bloc comprend trois bascules du type D cadencées par un même signal d'horloge qui est un signal de sortie d'un premier diviseur par deux. Cependant, une des bascules de ce bloc n'est utilisée que pour obtenir le facteur de division par 65 ou par 130.

Habituellement, un bloc de diviseurs synchrones de ce type est destiné à recevoir directement le signal à haute fréquence. Ainsi, plusieurs bascules fonctionnent à fréquence élevée ce qui est un inconvénient si l'on souhaite réduire la consommation d'un tel circuit compteur diviseur. Une solution à ce problème a été partiellement résolue par le circuit décrit dans ce brevet US 6,037,339 en plaçant un premier diviseur par deux du type asynchrone avant le bloc de diviseurs synchrones. Toutefois, le premier diviseur ne fait que diviser par deux la fréquence du signal à haute fréquence ce qui fait que le bloc doit fonctionner avec une fréquence qui est encore trop élevée.

Un autre inconvénient avec un tel montage est que la division de fréquence ne peut pas être ajustée finement selon les deux facteurs de division, étant donné qu'un premier diviseur par deux est notamment utilisé pour diminuer la fréquence d'un signal à haute fréquence. Il n'est donc pas possible de fournir des divisions de fréquence avec des facteurs de division plus proche l'un de l'autre.

Pour éviter l'utilisation d'un bloc de diviseurs synchrones, une forme d'exécution d'un circuit compteur diviseur double mode est présentée dans l'article rédigé par Mrs Jan Craninckx et Michiel S. J. Steyaert, publié dans le journal IEEE des circuits intégrés, volume 31 du 7 juillet 1996. Ce circuit compteur diviseur double mode ne comprend que des diviseurs par deux connectés en série du type asynchrone. Ce circuit à double mode comprend donc une chaîne de sept diviseurs par deux asynchrones interrompue par un bloc sélecteur de phase pour permettre une division de fréquence par 128 ou par 129. Uniquement le premier diviseur par deux fonctionne à la fréquence la plus élevée, c'est-à-dire à la fréquence d'au moins un signal à haute fréquence Fin reçu.

Un deuxième diviseur par deux du type maître-esclave est connecté au premier diviseur par deux. Ce second diviseur maître-esclave est destiné à fournir quatre signaux déphasés de 90° l'un par rapport à l'autre au bloc sélecteur de phase sur la base de deux signaux en opposition de phase fournis par le premier diviseur. Par rapport au premier des quatre signaux fournis par le diviseur maître-esclave, les autres signaux sont donc déphasés de 90°, 180° et 270°. Le bloc sélecteur comprend deux amplificateurs différentiels pour amplifier et sélectionner les quatre signaux déphasés, et des moyens de sélection pour fournir un des quatre signaux sélectionné en sortie.

Le bloc sélecteur est commandé par un bloc logique de commande en fonction du mode sélectionné. Dans un premier mode sélectionné, ledit circuit doit diviser la fréquence des signaux à haute fréquence par un facteur de division égal à 128. Dans ce cas, pour toutes les périodes de division, un seul des quatre signaux est sélectionné par le bloc sélecteur. Dans un second mode sélectionné, ledit circuit doit diviser la fréquence des signaux à haute fréquence par un facteur de division égal à 129. Pour obtenir ce facteur, une commutation de phase entre deux des quatre signaux déphasés est réalisée dans le bloc sélecteur en fonction des signaux de commande produits par le bloc de commande. A chaque période de division, une commutation de phase entre un premier signal fourni par le deuxième diviseur et un second signal en retard de phase de 90° par rapport au premier signal est donc réalisé. A cet effet, le bloc de commande est cadencé par le signal de sortie du dernier diviseur par deux pour fournir ainsi des signaux de commande au bloc sélecteur de phase pour la commutation de phase à chaque période de division.

Pour modifier l'état du bloc de commande en fonction d'un mode sélectionné, une porte logique du type NAND reçoit d'une part le signal de mode et le signal de sortie du dernier diviseur par deux. Lorsque le signal de mode vaut 0, la variation du signal de sortie sur le bloc de commande n'a aucun effet. Par contre lorsque le signal de mode vaut 1, le signal de sortie est inversé par la porte NAND afin de cadencer le bloc de commande et permettre au bloc sélecteur d'opérer la commutation de phase des signaux.

Un inconvénient d'un tel agencement du bloc logique de commande et de la porte NAND est que la partie de commande du bloc sélecteur n'est plus entièrement du type synchrone. De ce fait, un retard de commutation de signaux logiques peut survenir ce qui n'est pas souhaité même si un tel retard peut permettre d'éviter des chutes de potentiel lors de la commutation de phase des signaux en sortie du bloc sélecteur.

Un autre inconvénient de la solution décrite dans l'article de Mrs Craninckx et Steyaert est que les amplificateurs du bloc sélecteur consomme un courant important afin d'amplifier les signaux à fréquence relativement élevée. De ce fait, le bloc sélecteur intercalé entre deux diviseurs par deux de la chaîne de diviseurs n'a pas pour but essentiel de réduire la consommation du circuit par rapport à un circuit compteur diviseur double mode conventionnel.

L'invention a donc pour but principal de pallier les inconvénients de l'art antérieur en fournissant un circuit compteur diviseur double mode à haute vitesse ayant des moyens pour réduire la consommation dudit circuit.

A cet effet, l'invention a pour objet un circuit compteur diviseur double mode du type cité ci-devant, dans lequel le bloc sélecteur comprend des moyens de commutation commandés par des seconds signaux de commande fournis par le bloc de commande de manière à déconnecter l'alimentation électrique d'une des branches de sélection dans une période où l'autre branche est sélectionnée pour fournir un des quatre signaux déphasés en sortie du bloc sélecteur.

Un avantage du circuit compteur diviseur double mode, selon l'invention, est que le courant du bloc sélecteur peut être bien diminué sans affecter la rapidité du circuit et la stabilité des signaux lors de la commutation. La diminution du courant consommé peut être de 50% dans un premier mode sélectionné et de 20 à 30% dans le second mode sélectionné.

Dans le premier mode sélectionné, la fréquence des signaux à haute fréquence est divisée par un facteur N égal par exemple à 64. Dans le second mode sélectionné, la fréquence des signaux à haute fréquence est divisée par un facteur N+M égal par exemple à 64,5. Ainsi, dans le premier mode à chaque période de division, une des branches amplificatrices du bloc sélecteur est alimentée électriquement, alors que l'autre branche est déconnectée de l'alimentation électrique. Par contre dans le second mode sélectionné, les branches amplificatrices sont inversement ou alternativement alimentées et déconnectées de l'alimentation électrique à chaque période de division. L'alimentation de la branche déconnectée doit normalement intervenir un laps de temps précédent la commutation entre les branches, c'est pourquoi le gain en consommation n'est plus que de 20 à 30%.

Un autre avantage du circuit compteur diviseur double mode, selon l'invention, est qu'il est possible d'avoir des facteurs de division suffisamment proches de manière que la fréquence des signaux à haute fréquence puisse être ajustée finement dans la boucle à blocage de phase du synthétiseur de fréquence.

Un autre avantage du circuit compteur diviseur double mode, selon l'invention, est que le bloc de commande est cadencé de manière synchrone par un signal d'horloge correspondant au signal de sortie du dernier ou de l'avant-dernier diviseur par deux de la chaîne de diviseurs. Ce signal d'horloge n'est donc jamais interrompu pour cadencer les opérations dans le bloc de commande. Par ailleurs, les signaux de commande produits par ledit bloc de commande sont exempts de toutes perturbations et/ou de tout retard. Chaque signal de commande, pour les amplificateurs de chaque branche, est stabilisé avant chaque changement de signaux à sélectionner par un élément de sélection du bloc sélecteur.

Il est à noter que l'emploi de diviseurs par deux, notamment du type asynchrone, dans la chaîne de diviseurs facilite la réalisation dudit circuit compteur diviseur double mode à haute vitesse.

Les buts, avantages et caractéristiques du circuit compteur diviseur double mode apparaîtront mieux dans la description suivante de formes d'exécution illustrées par les dessins sur lesquels :
La figure 1 déjà citée représente un synthétiseur de fréquence conventionnel avec un circuit compteur diviseur double mode,
la figure 2 représente schématiquement les différents éléments qui composent le circuit compteur diviseur double mode selon l'invention,
la figure 3 représente les composants du bloc sélecteur de phase du circuit compteur diviseur double mode selon l'invention,
la figure 4a représente une première forme d'exécution du bloc de commande qui est constitué de plusieurs bascules et de portes logiques pour le circuit compteur diviseur double mode selon l'invention,
la figure 4b représente une seconde forme d'exécution du bloc de commande qui est constitué d'une mémoire non volatile et d'un compteur pour l'adressage de positions mémoire pour le circuit compteur diviseur double mode selon l'invention,
la figure 5a représente des graphiques de la commutation de phase entre des signaux déphasés dans le bloc sélecteur en fonction de la transition des signaux de commande, ainsi que le signal de sortie du bloc sélecteur résultant de la commutation de phase des signaux déphasés, et
la figure 5b représente des graphiques des premiers et seconds signaux de commande générés par le bloc de commande de phase du circuit compteur diviseur double mode selon l'invention.

Dans la description suivante, tous le composants du circuit compteur diviseur double mode, qui sont bien connus d'un homme du métier dans ce domaine technique, ne seront pas expliqués en détail. Par contre, la description suivante présente de manière plus détaillée les moyens permettant de réduire la consommation et d'éviter tous les problèmes lors de la commutation des signaux d'un tel circuit.

Comme décrit ci-devant en référence à la figure 1, le circuit compteur diviseur double mode est utilisé dans une boucle d'asservissement d'un synthétiseur de fréquence. Ce synthétiseur peut servir par exemple dans des dispositifs émetteurs et/ou récepteurs de signaux radiofréquences équipant des dispositifs portables de petite taille pour des communications sans fils à courte distance. La fréquence des signaux radiofréquences pour des communications courte distance est proche de 0,5 GHz, par exemple de 434 MHz. En général, ce synthétiseur sert à fournir des signaux à haute fréquence pour des opérations de démodulation des signaux radiofréquences. Le synthétiseur peut être prévu pour équiper par exemple une montre-bracelet qui comprend une batterie ou un accumulateur de petite taille. Ainsi, il est nécessaire que le circuit compteur diviseur double mode consomme peu de courant dans les périodes de fonctionnement du synthétiseur.

Le circuit compteur diviseur double mode, objet de l'invention, se base en partie sur le circuit présenté dans l'article rédigé par Mrs Jan Craninckx et Michiel S. J. Steyaert, publié dans le journal IEEE des circuits intégrés, volume 31 du 7 juillet 1996. Ainsi, le lecteur peut se reporter audit article pour plus de détails de conception de certains éléments équivalents du circuit compteur diviseur double mode, objet de l'invention.

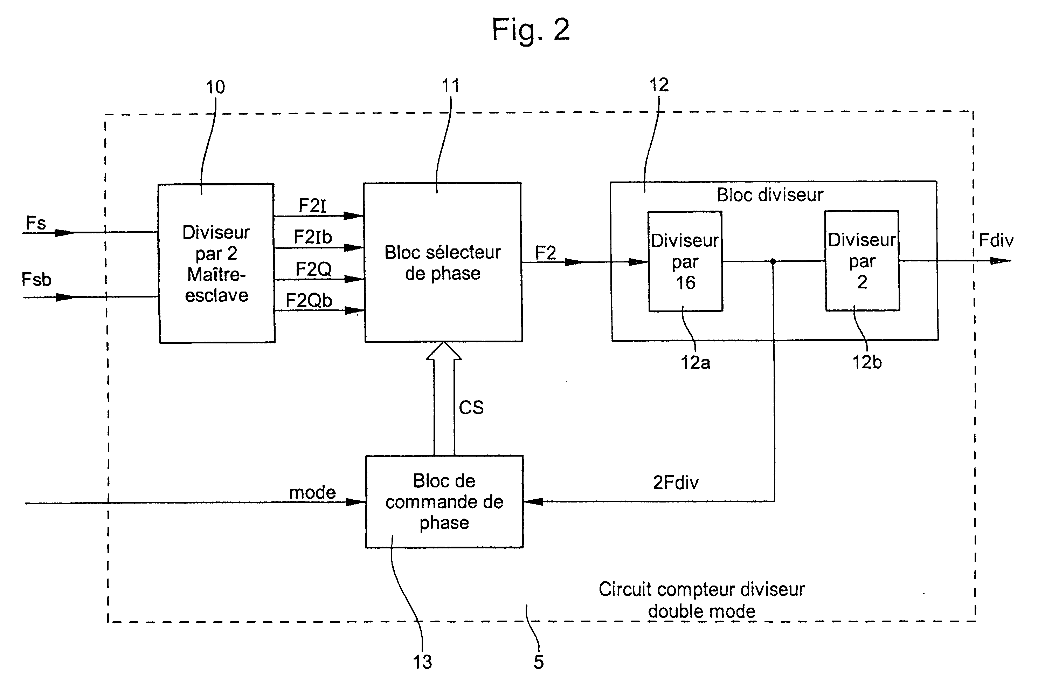

Les différents éléments du circuit compteur diviseur double mode 5 sont présentés à la figure 2. Le circuit est destiné à opérer une division par un facteur N dans un premier mode sélectionné et par un facteur N+M dans un second mode sélectionné. De préférence, le facteur N est égal à 64, qui est une puissance de 2, alors que le facteur N+M est égal à 64,5. Bien entendu, d'autres valeurs de facteurs de division peuvent être choisis. Si le bloc sélecteur est par exemple intercalé entre les deuxième et troisième diviseurs par deux, les facteurs de division seront 64 ou 65.

Le circuit compteur diviseur double mode 5 comprend une chaîne de diviseurs par deux asynchrones 10, 12, un bloc sélecteur de phase 11 intercalé entre deux diviseurs par deux, et un bloc de commande de phase 13 relié au bloc sélecteur pour lui fournir des signaux de commande CS dépendant du mode sélectionné.

Le premier diviseur par deux 10 est un diviseur maître-esclave. Ce diviseur fournit, au bloc sélecteur de phase 11, quatre signaux déphasés de 90° l'un par rapport à l'autre F2l, F2lb, F2Q et F2Qb en fonction de deux signaux à haute fréquence en opposition de phase Fs et Fsb. Les deux signaux à haute fréquence sont fournis par l'oscillateur différentiel commandé en tension (VCO) du synthétiseur. Il est à noter que le premier diviseur maître-esclave est le seul élément qui fonctionne à la plus haute fréquence.

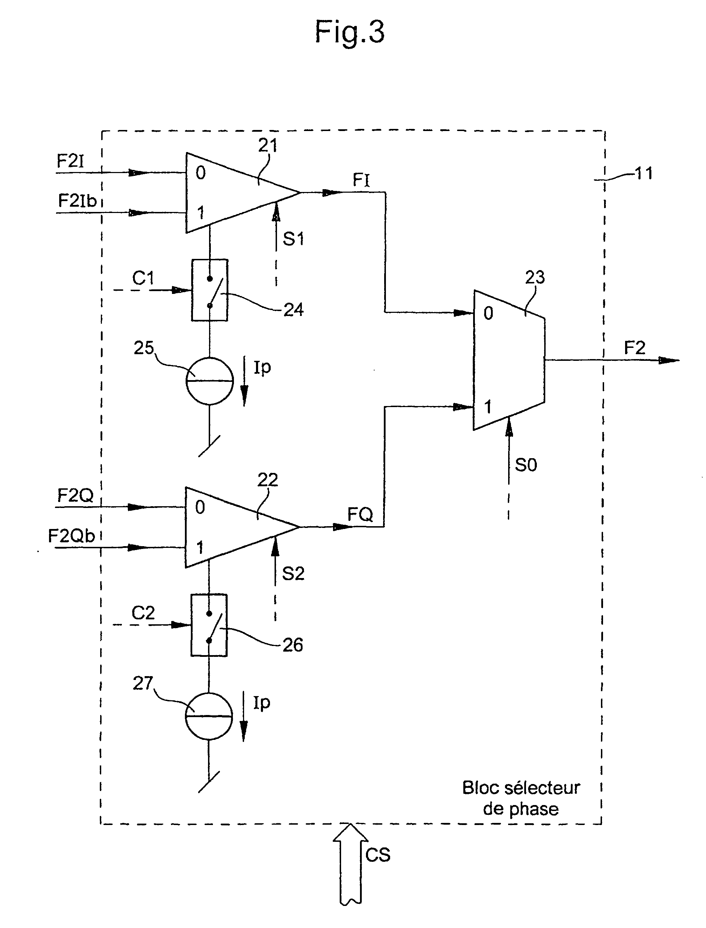

Le bloc sélecteur de phase 11, qui sera expliqué plus en détail en référence à la figure 3, est intercalé entre le premier diviseur maître-esclave 10 et le premier diviseur par deux du bloc diviseur 12. Dans un premier mode sélectionné, aucune commutation de phase n'est opérée dans le bloc sélecteur de phase 11. Ainsi, le bloc sélecteur ne sélectionne qu'un des quatre signaux déphasés pour fournir un signal de sortie F2 à la même fréquence que le signal déphasé sélectionné. Le même signal déphasé constitue le signal de sortie F2 du bloc sélecteur à chaque période de division. Cette période de division est définie par rapport à la fréquence du signal à fréquence divisée Fdiv en sortie du circuit compteur diviseur. Dans ce premier mode, les signaux de commande CS fournis par le bloc de commande ne varient donc pas au cours du temps.

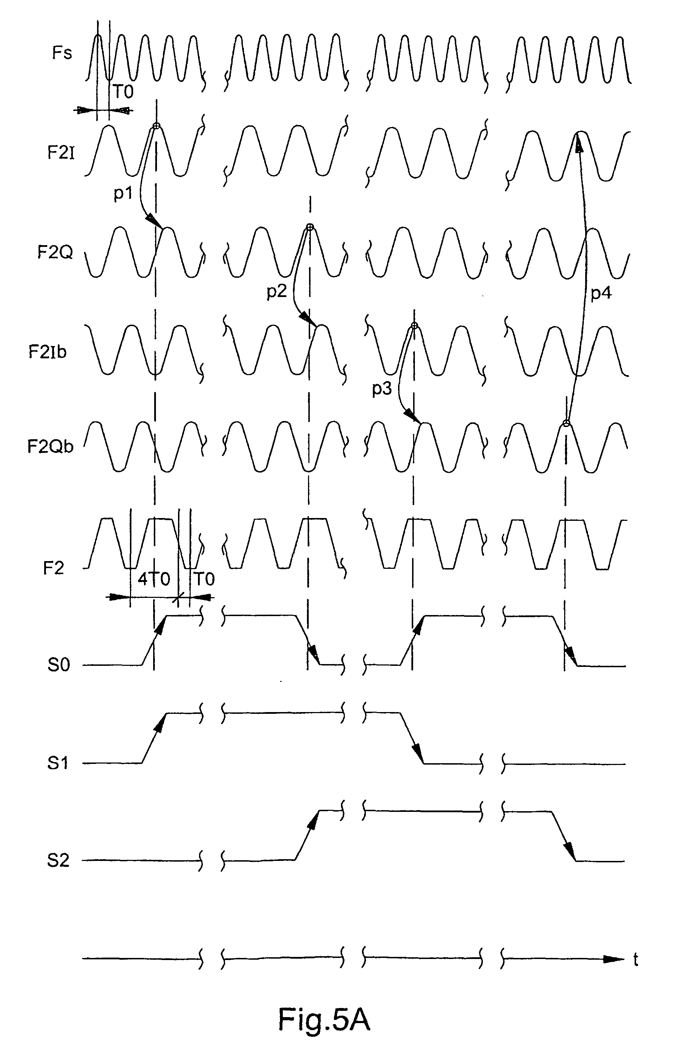

Dans un second mode sélectionné, une commutation de phase est opérée dans le bloc sélecteur à la fin de chaque période de division. La commutation de phase dans le bloc sélecteur correspond à une transition entre un premier signal reçu à l'entrée du bloc sélecteur et un second signal en retard de phase de 90°. Ainsi, le bloc sélecteur 11 reçoit des signaux de commande CS dont certains changent d'état à chaque période de division 1/Fdiv pour la commutation de phase. Comme l'écart de phase entre chaque signal déphasé est de 90° et qu'un seul diviseur par deux précède le bloc sélecteur, le facteur de division peut ainsi être égal à 64,5. Six diviseurs par deux, associés au bloc sélecteur de phase, sont employés pour obtenir un tel facteur dans la présente invention. La commutation de phase, c'est-à-dire la transition entre deux des quatre signaux déphasés à chaque période de division, sera expliquée notamment en référence à la figure 5a.

La fréquence du signal de sortie F2 provenant du bloc sélecteur de phase 11 est divisée dans un diviseur par seize 12a du bloc diviseur 12. Ce diviseur par seize n'est autre que quatre diviseurs par deux connectés en série du type asynchrone. Le signal de sortie 2Fdiv de ce diviseur par seize va servir de signal d'horloge pour le bloc de commande de phase 13 afin de cadencer les opérations traitées par ce bloc de commande. Finalement, un dernier diviseur par deux 12b du bloc diviseur 12 fournit le signal à fréquence divisée Fdiv nécessaire pour la comparaison dans le détecteur de phase et de fréquence du synthétiseur de fréquence.

Le bloc sélecteur de phase, qui est l'élément principal de ce circuit dans le but de réduire notamment la consommation, va être expliqué maintenant en référence à la figure 3. Ce bloc sélecteur 11 est composé de deux branches de sélection. Ces branches amplificatrices comprennent chacune un amplificateur différentiel 21 et 22. Chaque amplificateur 21 ou 22 reçoit deux des quatre signaux déphasés provenant du premier diviseur maître-esclave. Comme les signaux de ce diviseur ont une amplitude relativement faible, il est nécessaire d'amplifier lesdits signaux à l'aide de ces amplificateurs des deux branches.

L'amplificateur 21 reçoit par exemple les signaux en phase positif et négatif F2l et F2lb, c'est-à-dire deux premiers signaux en opposition de phase, alors que l'amplificateur 22 reçoit les signaux en quadrature positif et négatif F2Q et F2Qb, c'est-à-dire deux seconds signaux en opposition de phase. Une sélection d'un des deux signaux dans chaque branche est réalisée à l'aide de premiers signaux de commande S1, S2. Un signal de commande S1 permet de sélectionner soit le signal F2l, soit le signal F2lb. Lorsque le signal de commande S1 vaut 0, le signal F2l est amplifié et sélectionné par l'amplificateur 21, alors que lorsque le signal de commande S1 vaut 1, le signal opposé F2lb est amplifié et sélectionné par l'amplificateur 21. De même, un signal de commande S2 permet de sélectionner soit le signal F2Q, soit le signal F2Qb. Lorsque le signal de commande S2 vaut 0, le signal F2Q est amplifié et sélectionné par l'amplificateur 22, alors que lorsque le signal de commande S2 vaut 1, le signal opposé F2Qb est amplifié et sélectionné par l'amplificateur 22. On comprend bien que le choix des signaux déphasés pour chaque amplificateur peut être changé, mais pour la présente invention il s'avère qu'il est préférable de choisir les signaux décrits ci-dessus pour chaque amplificateur.

Les amplificateurs sont alimentés par exemple chacun par une source de courant 25 et 27 dont la valeur du courant Ip doit être suffisamment importante pour garantir un fonctionnement rapide du circuit compteur diviseur double mode. Afin de réduire la consommation du circuit compteur diviseur, il est donc préconisé de couper l'alimentation électrique, c'est-à-dire de déconnecter une des sources de courant, de l'amplificateur de la branche inutilisée dans une période de division. Pour ce faire, dans la première branche, un premier interrupteur 24 est connecté en série entre une borne de la source de courant 25 et une borne de l'amplificateur 21 pour son alimentation électrique. Dans la seconde branche, un second interrupteur 26 est connecté en série entre une borne de la source de courant 27 et une borne de l'amplificateur 22 pour son alimentation électrique.

Les interrupteurs 24, 26 sont commandés par des seconds signaux de commande produits par le bloc de commande de phase de manière à connecter ou à déconnecter chaque source de courant 25, 27. Dans la première branche, lorsque le signal de commande C1 est à 1, l'interrupteur 24 est fermé et permet à la source de courant 25 d'alimenter l'amplificateur 21, alors que lorsque le signal C1 est à 0, l'interrupteur 24 est ouvert ce qui coupe l'alimentation électrique de l'amplificateur 21. Dans la seconde branche, lorsque le signal de commande C2 est à 1, l'interrupteur 26 est fermé et permet à la source de courant 27 d'alimenter l'amplificateur 22, alors que lorsque le signal C2 est à 0, l'interrupteur 26 est ouvert ce qui coupe l'alimentation électrique de l'amplificateur 22.

Comme déjà mentionné ci-dessus, chaque branche inutilisée dans au moins une période de division est déconnectée de l'alimentation électrique. Dans le premier mode sélectionné, un des deux interrupteurs 24 ou 26 reste ouvert, et l'autre reste fermé à chaque période de division. Cela permet de gagner environ 50% du courant consommé dans ledit bloc sélecteur. Dans le second mode sélectionné, les deux interrupteurs 24 et 26 sont, en principe, inversement ou alternativement fermés et ouverts de manière à déconnecter de l'alimentation électrique chaque branche inutilisée après chaque période de division. Cependant lors de la sélection d'un des signaux déphasés d'une branche déconnectée dans une période de division subséquente, l'interrupteur de la branche déconnectée doit être fermé un laps de temps précédent la sélection du signal de cette branche. Le laps de temps peut valoir une demi période de division. Ceci est nécessaire pour stabiliser les signaux de manière à éviter des problèmes lors de la commutation de phase.

Les interrupteurs 24 et 26 utilisés dans le bloc sélecteur peuvent être des transistors du type MOS, par exemple NMOS. Lorsque la grille de chaque transistor est à 1, le transistor est conducteur et permet à l'amplificateur correspondant d'être alimenté. Lorsque la grille de chaque transistor est à 0, l'amplificateur correspondant n'est pas alimenté électriquement. Bien entendu, d'autres types d'interrupteurs peuvent être utilisés. De même, au lieu d'alimenter chaque amplificateur par la source de courant, une source de tension peut être utilisée. Dans ce cas chaque interrupteur doit être placé par exemple entre une borne positive de la source de tension et la borne d'alimentation de l'amplificateur correspondant.

Le bloc sélecteur de phase 11 comprend encore un élément de sélection 23 d'un des signaux déphasés à fournir en sortie dudit bloc. L'élément de sélection peut être par exemple un multiplexeur. Cet élément de sélection reçoit les signaux FI et FQ de chaque branche, ainsi qu'un signal de commande S0 faisant partie des premiers signaux de commande. Ce signal S0 permet, à l'élément de sélection 23, de sélectionner l'un ou l'autre des signaux FI et FQ à fournir en sortie.

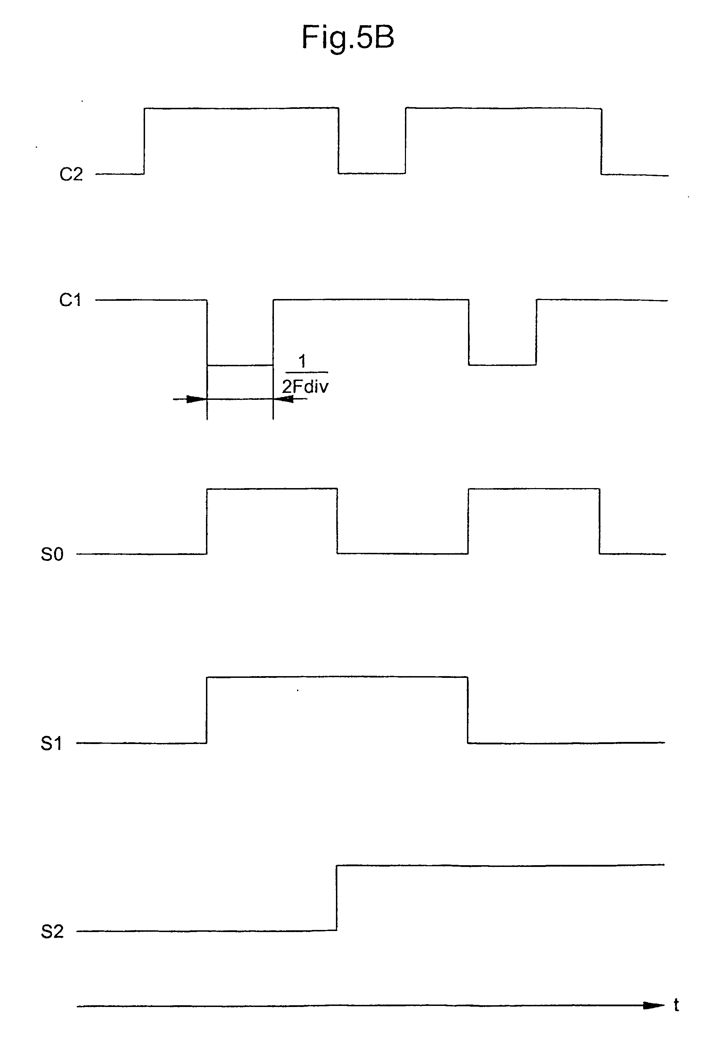

L'état des premiers et seconds signaux de commande sont montrés à la figure 5b lorsque le circuit compteur diviseur se trouve dans le second mode sélectionné. On remarque sur cette figure que les deux signaux C1 et C2 sont respectivement à l'état 1 avant chaque sélection de la branche qui doit fournir un des signaux déphasés sélectionné. Lorsque le signal de commande S0 passe de l'état 0 à l'état 1 pour sélectionner un des signaux de la seconde branche, l'alimentation de cette branche doit être rétablie par exemple une demi période de division au préalable par le signal C2 à l'état 1. Lorsque le signal de commande S0 passe de l'état 1 à l'état 0 pour sélectionner un des signaux de la première branche, l'alimentation de cette branche doit être rétablie également une demi période de division au préalable par le signal C1 à l'état 1. La branche inutilisée n'est donc déconnectée de l'alimentation qu'une demi période de division. De ce fait, le gain en courant dans ce second mode est approximativement entre 20 et 30%.

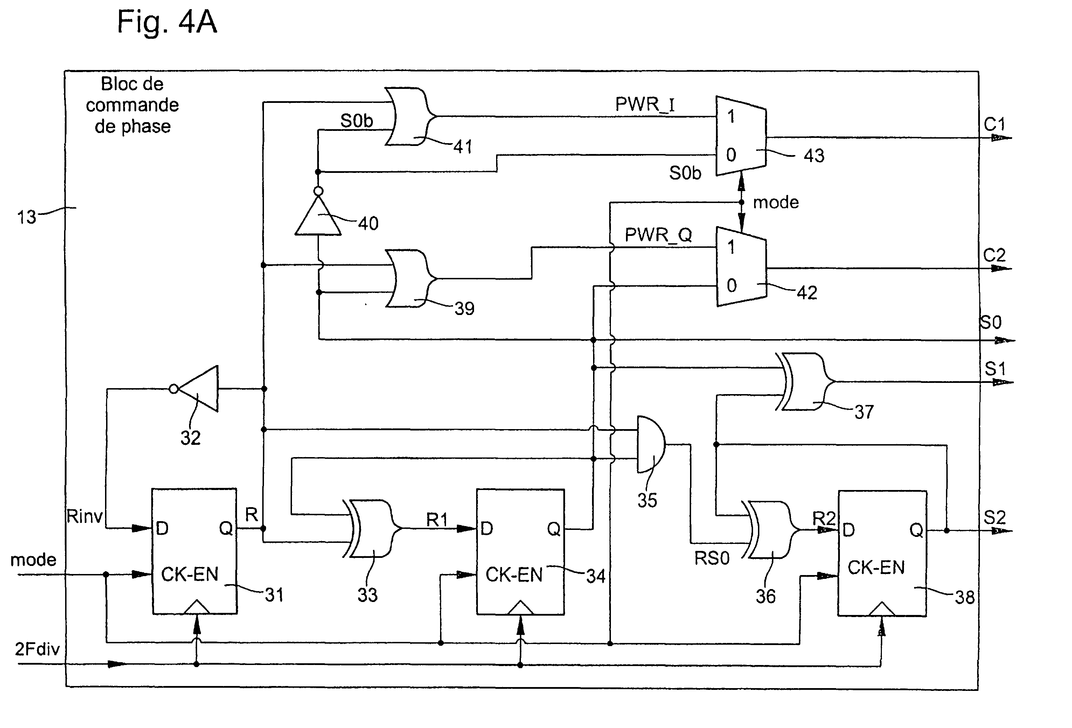

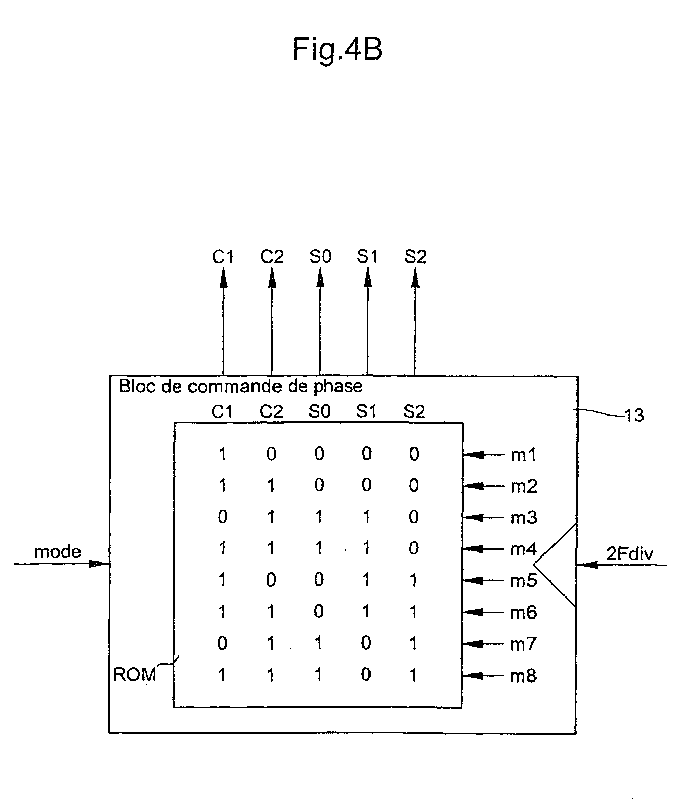

Deux formes d'exécution du bloc de commande de phase vont maintenant être décrites en référence aux figures 4a et 4b.

Le bloc de commande de phase 13, représenté à la figure 4a, peut être configuré pour fournir des signaux de commande S0, S1, S2, C1 et C2 au bloc sélecteur dépendant de l'état d'un signal de mode. Dans cette première forme d'exécution, le bloc de commande 13 comprend une partie à logique séquentielle et une partie à logique combinatoire. La partie à logique séquentielle comprend trois bascules 31, 34 et 38, et la partie à logique combinatoire comprend un agencement de portes logiques 32, 33, 35, 36, 37, 39 à 43. Il est à noter que la partie à logique séquentielle est cadencée de manière synchrone par un unique signal d'horloge 2Fdiv. Ce signal d'horloge est le signal de sortie de l'avant-dernier diviseur par deux de la chaîne de diviseurs.

Lorsque le signal de mode est à l'état 1, toutes les bascules de type D transmettent l'état du signal d'entrée à leur sortie Q à chaque coup d'horloge produit par le signal 2Fdiv. Par contre, lorsque le signal de mode est à l'état 0, l'état des sorties de chaque bascule ne fluctue pas à chaque coup d'horloge produit par le signal 2Fdiv.

Un inverseur 32 est connecté entre la sortie Q de la première bascule 31 et l'entrée D afin que le signal de sortie R soit inversé par ledit inverseur pour donner le signal Rinv. De ce fait, à chaque coup d'horloge, le signal R change d'état. Il passe de l'état bas à l'état haut quand le signal Rinv est à l'état haut, et il passe de l'état haut à l'état bas quand le signal Rinv est à l'état bas.

Une porte logique XOR 33 reçoit à l'entrée le signal R et le signal de sortie Q de la deuxième bascule 34, et fournit un signal R1 à l'entrée de la deuxième bascule. Une porte logique AND 35 reçoit en entrée le signal R et le signal de sortie Q de la deuxième bascule, et fournit un signal RS0. Une porte logique XOR 36 reçoit le signal RS0 de la porte logique 35, ainsi que le signal de sortie Q de la troisième bascule 38 et fournit un signal R2 à l'entrée de la troisième bascule.

Le signal de commande S0 correspond au signal de sortie Q de la deuxième bascule 34. Le signal de commande S1 est obtenu par une porte logique XOR 37 qui reçoit à l'entrée le signal S0 et le signal de sortie Q de la troisième bascule 38. Finalement, le signal de commande S2 correspond au signal de sortie Q de la troisième bascule 38.

Les seconds signaux de commande C1 et C2 sont obtenus sur la base du signal de commande S0 et du signal de sortie R de la première bascule 31. La porte logique OR 41 additionne le signal R et un signal S0b, qui provient du signal de commande S0 inversé par l'inverseur 40, et fournit le signal PWR_I. La porte logique OR 39 additionne le signal R et le signal S0, et fournit le signal PWR_Q.

Le multiplexeur 43 reçoit le signal S0b et le signal PWR_I. Si le mode est à 1, ledit multiplexeur 43 fournit le signal PWR_I comme le signal de commande C1. Si le mode est à 0, le multiplexeur fournit le signal S0b comme le signal de commande C1.

Le multiplexeur 42 reçoit le signal S0 et le signal PWR_Q. Si le mode est à 1, ledit multiplexeur 42 fournit le signal PWR_Q comme le signal de commande C2. Si le mode est à 0, le multiplexeur fournit le signal S0 comme le signal de commande C2.

L'état de chaque signal de commande dans le second mode sélectionné, c'est-à-dire quand le signal mode est à l'état 1 est représenté à la figure 5a décrite ci-dessus.

Malgré la relative complexité de ce bloc de commande et de la multitude de bascules et de portes logique pour fournir les signaux de commande, le gain en consommation est tout de même conséquent. Le bloc de commande fonctionne avec des signaux dont la fréquence est plus de 16 fois inférieure aux signaux déphasés placés à l'entrée des amplificateurs de chaque branche. La faible consommation en courant des bascules et des portes logiques de ce bloc 13 n'affecte que dans une moindre mesure la consommation du circuit compteur diviseur double mode comparativement au bloc sélecteur de phase 11.

Le bloc de commande de phase 13, représenté à la figure 4b, peut être configuré pour fournir les premiers et seconds signaux de commande C1, C2, S0, S1 et S2 au bloc sélecteur de phase dépendant de l'état d'un signal de mode. Dans cette seconde forme d'exécution, le bloc de commande de phase 13 comprend un compteur, non représenté, et une mémoire non volatile du type ROM.

La mémoire ROM comprend un certain nombre de positions mémoire dans lesquelles sont enregistrés des mots binaires de 5 bits représentant l'état de chaque signal de commande à un instant donné. Dans le second mode sélectionné, toutes les positions mémoire sont adressables successivement de manière cyclique par le compteur. Le compteur passe donc d'une adresse précédente d'une position mémoire m1 à m8 à une adresse successive à chaque coup d'horloge. Ce signal d'horloge est produit par le signal de sortie 2Fdiv de l'avant-dernier diviseur par deux de la chaîne de diviseurs. De ce fait, certains signaux de commande changent d'état à chaque coup d'horloge en passant d'une position mémoire précédente à une position mémoire suivante. Dans le premier mode sélectionné, uniquement une position mémoire est sélectionnée dans laquelle une des branches est déconnectée quand l'autre branche active fournit un signal sélectionné. La position mémoire à l'adresse m1, par exemple, peut être sélectionnée quand le mode est à 0.

Ce bloc de commande avec la mémoire ROM ne sera pas décrit de manière détaillée, car il fait partie des connaissances générales d'un homme du métier dans ce domaine technique.

La commutation des signaux déphasés dans le bloc sélecteur de phase en fonction des signaux de commande est expliquée maintenant en référence à la figure 5a. Cette figure présente plusieurs graphiques des signaux notamment au niveau du bloc sélecteur. Les quatre commutations de phase p1 à p4 dans le bloc sélecteur intervenant à chaque période de division sont montrées.

Sur les graphiques, les signaux Fs, F2l, F2Ib, F2Q et F2Qb sont représentés de forme approximativement sinusoïdale. Il faut savoir que le premier diviseur maître-esclave fonctionne à haute fréquence, c'est pourquoi il est plus avantageux d'avoir des signaux de forme sinusoïdale plutôt que des signaux à impulsions rectangulaires. Cela permet d'éviter d'avoir un spectre de fréquence trop étendu dans le cas où les signaux sont à impulsions rectangulaires, et de réduire la consommation de ce premier diviseur.

Le signal à haute fréquence Fs a une fréquence qui peut être de l'ordre de 434 MHz. Après le premier diviseur par deux, les signaux déphasés F2l, F2Q, F2Ib et F2Qb ont tous une fréquence divisée par deux de la fréquence du signal Fs. Par rapport au signal F2l, le signal F2Q a un retard de phase de 90°, le signal F2lb a un retard de phase de 180° et le signal F2Qb a un retard de phase de 270°. Chaque signal F2l, F2Q, F2lb et F2Qb est donc déphasé l'un par rapport à l'autre d'une demi période T0 du signal Fs.

Lorsque le signal S2 est à l'état 0 et que les signaux S0 et S1 passent de l'état 0 à l'état 1, une première commutation de phase p1 entre le signal F2l et F2Q est opérée dans le bloc sélecteur. Ainsi le signal de sortie F2, devant représenter un des signaux déphasés sélectionné, a une impulsion plus longue d'une demi période T0 à la fin de chaque période de division due à la commutation de phase.

Lorsque le signal S1 est à l'état 1 et que le signal S0 passe de l'état 1 à l'état 0 et que le signal S2 passe de l'état 0 à l'état 1, une seconde commutation de phase p2 entre le signal F2Q et F2lb est opérée dans le bloc sélecteur. De nouveau, le signal de sortie F2 a une impulsion plus longue d'une demi période du signal Fs à la fin de la période de division due à la commutation de phase.

Lorsque le signal S2 est à l'état 1 et que le signal S0 passe de l'état 0 à l'état 1 et que le signal S1 passe de l'état 1 à l'état 0, une troisième commutation de phase p3 entre le signal F2lb et F2Qb est opérée dans le bloc sélecteur. De nouveau, le signal de sortie F2 a une impulsion plus longue d'une demi période du signal Fs à la fin de la période de division due à la commutation de phase.

Finalement, lorsque le signal S1 est à l'état 0 et que les signaux S0 et S2 passent de l'état 1 à l'état 0, une quatrième commutation de phase p4 entre le signal F2Qb et F2l est opérée dans le bloc sélecteur. De nouveau, le signal de sortie F2 a une impulsion plus longue d'une demi période du signal Fs à la fin de la période de division due à la commutation de phase.

On comprend donc bien qu'en augmentant d'une demi période du signal Fs l'impulsion du signal F2 à chaque période de division, le circuit compteur diviseur divise la fréquence du signal Fs par 64,5.

Il est encore à noter que le circuit compteur diviseur double mode peut permettre de diviser la fréquence des signaux à haute fréquence dont la fréquence est supérieure à 2 GHz. Par contre, lorsque lesdits signaux ont une fréquence relativement basse, certains problèmes de chutes de tension peuvent survenir lors de la commutation de phase.

A partir de la description qui vient d'être faite de multiples variantes de réalisation du circuit compteur diviseur, peuvent être conçues par l'homme du métier sans sortir du cadre de l'invention définie par les revendications.

## Revendications

1. Circuit compteur diviseur double mode notamment pour un synthétiseur de fréquence (1), ledit circuit divisant la fréquence d'au moins un signal à haute fréquence (Fs) par un facteur N dans un premier mode sélectionné et par un facteur N+M dans un second mode sélectionné, ledit circuit comprenant :
- plusieurs diviseurs par deux (10, 12) connectés en série du type asynchrone, un des diviseurs étant du type maître-esclave (10) pour recevoir deux signaux d'entrée (Fs, Fsb) en opposition de phase et fournir quatre signaux déphasés de 90° (F2l, F2lb, F2Q, F2Qb) l'un par rapport à l'autre,
- un bloc sélecteur de phase (11) intercalé entre deux des diviseurs (10, 12a) par deux pour recevoir les quatre signaux déphasés du premier diviseur maître-esclave et fournir un des quatre signaux déphasés sélectionné au second diviseur, ledit bloc sélecteur comprenant une première branche de sélection (21) recevant deux premiers signaux déphasés (F2I, F2Ib), une seconde branche de sélection (22) recevant deux seconds signaux déphasés (F2Q, F2Qb), et un élément de sélection (23) relié à chaque branche, des premiers signaux de commande (S0, S1, S2) étant fournis aux première et seconde branches, ainsi qu'à l'élément de sélection afin que ledit bloc sélecteur fournisse un des quatre signaux déphasés sélectionné (F2) en sortie dans une période de division déterminée en fonction du mode sélectionné,
- un bloc de commande pour fournir les premiers signaux de commande au bloc sélecteur, ledit bloc de commande recevant un signal de sortie (2Fdiv) d'un des diviseurs par deux pour cadencer des opérations dans le bloc de commande, et un signai pour la sélection du mode,
le circuit étant **caractérisé en ce que** le bloc sélecteur comprend des moyens de commutation (24, 26) commandés par des seconds signaux de commande (C1, C2) fournis par le bloc de commande de manière à déconnecter l'alimentation électrique d'une des branches de sélection dans une période où l'autre branche est sélectionnée pour fournir un des quatre signaux déphasés en sortie du bloc sélecteur.

2. Circuit compteur diviseur selon la revendication 1, **caractérisé en ce que** chaque branche est constituée d'un amplificateur différentiel (21, 22) pour amplifier les signaux déphasés reçus, chaque amplificateur étant commandé par un des premiers signaux de commande respectifs (S1, S2) afin de fournir à leur sortie un des deux signaux déphasés.

3. Circuit compteur diviseur selon la revendication 1, **caractérisé en ce que** le bloc de sélection de phase est inséré entre le premier et le deuxième diviseurs par deux pour recevoir les quatre signaux du premier diviseur par deux (10) qui est du type maître/esclave.

4. Circuit compteur diviseur selon l'une des revendications précédentes, **caractérisé en ce qu'**il comprend six diviseurs par deux (10, 12) du type asynchrone pour obtenir une division de fréquence par un facteur N égal à 64 dans un premier mode, dans lequel les premiers signaux de commande (C1, C2, S0, S1, S2) ne changent pas d'état à chaque période de division déterminée pour qu'un seul des quatre signaux déphasés soit sélectionné dans le bloc sélecteur à chaque période de division, et pour obtenir une division de fréquence par un facteur N+M égal à 64,5 dans un second mode, dans lequel, pour chaque période de division déterminée, certains premiers signaux de commande changent d'état pour opérer une commutation de phase entre un premier signal déphasé et un second signal déphasé en retard de phase de 90° du premier signal déphasé afin que le bloc sélecteur fournisse en sortie un des quatre signaux déphasés différent à la fin de chaque période de division.

5. Circuit compteur diviseur selon la revendication 2, **caractérisé en ce que** les moyens de commutation comprennent un premier interrupteur (24) commandé par un des seconds signaux de commande (C1) pour connecter ou déconnecter l'alimentation électrique de l'amplificateur différentiel (21) de la première branche amplificatrice, et un second interrupteur (26) commandé par un autre des seconds signaux de commande (C2) pour connecter ou déconnecter l'alimentation électrique de l'amplificateur différentiel (22) de la seconde branche amplificatrice.

6. Circuit compteur diviseur selon la revendication 5, **caractérisé en ce que** les seconds signaux de commande (C1, C2) sont agencés pour fermer l'interrupteur d'une des branches inutilisée afin d'alimenter l'amplificateur correspondant un laps de temps précédent la sélection d'un des signaux déphasés dudit amplificateur par l'élément de sélection (23).

7. Circuit compteur diviseur selon la revendication 1, **caractérisé en ce que** le bloc de commande comprend une série de bascules (31; 34; 38) cadencées de façon synchrone par le signal de sortie (2Fdiv) de l'avant-dernier diviseur par deux, et un agencement de portes logiques pour la fourniture des signaux de commande au bloc sélecteur.

8. Circuit compteur diviseur selon la revendication 1, **caractérisé en ce que** le bloc de commande comprend une mémoire non volatile, par exemple une mémoire du type ROM, dans laquelle plusieurs mots binaires sont enregistrés dans des positions déterminées (m1 à m8), chaque mot binaire représentant l'état des premiers et seconds signaux de commande pour chaque demi période de division déterminée, et un compteur cadencé par le signal de sortie de l'avant-dernier diviseur par deux de manière à adresser à chaque transition du compteur une position mémoire successive dans le second mode sélectionné ou à maintenir une position mémoire déterminée dans le premier mode sélectionné.

9. Circuit compteur diviseur selon l'une des revendications 1, 2 et 4, **caractérisé en ce que** la première branche reçoit deux signaux déphasés en opposition de phase (F2l, F2lb), **en ce que** la seconde branche reçoit deux autres signaux déphasés en opposition de phase (F2Q, F2Qb), et **en ce que** les signaux de commande sont agencés de telle manière que, lors d'une commutation de phase entre des premier et second signaux déphasés sélectionnés dans l'élément de sélection du bloc sélecteur, la sélection du second signal déphasé dans une des branches respectives est réalisée dans une période précédent la commutation de phase dans l'élément de sélection.

## Patentansprüche

1. Doppelbetriebsart-Zähler/Teiler-Schaltung insbesondere für einen Frequenzsynthetisierer (1), wobei die Schaltung die Frequenz wenigstens eines Hochfrequenzsignals (Fs) in einer ersten ausgewählten Betriebsart durch einen Faktor N und in einer zweiten ausgewählten Betriebsart durch einen Faktor N + M teilt, wobei die Schaltung umfasst:
- mehrere Teiler (10, 12) durch zwei, die in Reihe geschaltet und vom asynchronen Typ sind, wobei einer der Teiler vom Master/Slave-Typ (10) ist, der zwei Eingangssignale (Fs, Fsb) mit entgegengesetzter Phase empfängt und vier um 90° zueinander phasenverschobene Signale (F2l, F2lb, F2Q, F2Qb) ausgibt,
- einen Phasenauswahlblock (11), der zwischen die zwei Teiler (10, 12a) durch zwei geschaltet ist, um die vier phasenverschobenen Signale des ersten Master/Slave-Teilers zu empfangen und um ein ausgewähltes der vier phasenverschobenen Signale an den zweiten Teiler auszugeben, wobei der Auswahlblock einen ersten Auswahlzweig (21), der zwei erste phasenverschobene Signale (F2I, F2Ib) empfängt, einen zweiten Auswahlzweig (22), der zwei zweite phasenverschobene Signale (F2Q, F2Qb) empfängt, und ein mit jedem Zweig verbundenes Auswahlelement (23) umfasst, wobei an den ersten und an den zweiten Zweig sowie an das Auswahlelement erste Steuersignale (S0, S1, S2) ausgegeben werden, damit der Auswahlblock in einer in Abhängigkeit von der ausgewählten Betriebsart bestimmten Teilungsperiode ein ausgewähltes (F2) der vier phasenverschobenen Signale an den Ausgang ausgibt,
- einen Steuerblock, um die ersten Steuersignale an den Auswahlblock auszugeben, wobei der Steuerblock ein Ausgangssignal (2Fdiv) eines der Teiler durch zwei empfängt, das die Operationen in dem Steuerblock taktet, und ein Signal für die Auswahl der Betriebsart empfängt,
wobei die Schaltung **dadurch gekennzeichnet ist dass** der Auswahlblock Umschaltmittel (24, 26) umfasst, die durch zweite von dem Steuerblock ausgegebene Steuersignale (C1, C2) gesteuert werden, derart, dass die elektrische Versorgung eines der Auswahlzweige in einer Periode, in der der andere Zweig ausgewählt ist, um eines der vier phasenverschobenen Signale an den Ausgang des Auswahlblocks auszugeben, unterbrochen wird.

2. Zähler/Teiler-Schaltung nach Anspruch 1, **dadurch gekennzeichnet, dass** jeder Zweig aus einem Differenzverstärker (21, 22) gebildet ist, um die empfangenen phasenverschobenen Signale zu verstärken, wobei jeder Verstärker durch ein entsprechendes der ersten Steuersignale (S1, S2) gesteuert wird, um an seinem Ausgang eines der zwei phasenverschobenen Signale auszugeben.

3. Zähler/Teiler-Schaltung nach Anspruch 1, **dadurch gekennzeichnet, dass** der Phasenauswahlblock zwischen den ersten und den zweiten Teiler durch zwei eingefügt ist, um die vier Signale des ersten Teilers (10) durch zwei, der vom Master/Slave-Typ ist, zu empfangen.

4. Zähler/Teiler-Schaltung nach einem der vorhergehenden Ansprüche, **dadurch gekennzeichnet, dass** sie sechs Teiler (10, 12) durch zwei des asynchronen Typs umfasst, um eine Frequenzteilung durch einen Faktor N auszuführen, der in einer ersten Betriebsart, in der die ersten Steuersignale (C1, C2, S0, S1, S2) ihren Zustand nicht in jeder bestimmten Teilungsperiode ändern, damit in dem Auswahlblock nur eines der vier phasenverschobenen Signale in jeder Teilungsperiode gewählt wird, gleich 64 ist, und um eine Frequenzteilung durch einen Faktor N + M auszuführen, der in einer zweiten Betriebsart, in der für jede bestimmte Teilungsperiode bestimmte erste Steuersignale ihren Zustand ändern, um eine Phasenumschaltung zwischen einem ersten phasenverschobenen Signal und einem zweiten phasenverschobenen Signal, das zu dem ersten phasenverschobenen Signal um 90° phasenverzögert ist, damit der Auswahlblock am Ausgang am Ende jeder Teilungsperiode ein anderes der vier phasenverschobenen Signale ausgibt, gleich 64,5 ist.

5. Zähler/Teiler-Schaltung nach Anspruch 2, **dadurch gekennzeichnet, dass** die Umschaltmittel einen ersten Ein/Aus-Schalter (24), der durch eines der zweiten Steuersignale (C1) gesteuert wird, um die elektrische Versorgung des Differenzverstärkers (21) des ersten Verstärkungszweigs anzuschließen oder zu trennen, und einen zweiten Ein/Aus-Schalter (26), der durch ein anderes der zweiten Steuersignale (C2) gesteuert wird, um die elektrische Versorgung des Differenzverstärkers (22) des zweiten Verstärkungszweigs anzuschließen oder zu trennen, umfasst.

6. Zähler/Teiler-Schaltung nach Anspruch 5, **dadurch gekennzeichnet, dass** die zweiten Steuersignale (C1, C2) so beschaffen sind, dass sie den Ein/Aus-Schalter eines nicht verwendeten der Zweige schließen, um den entsprechenden Verstärker für einen bestimmten Zeitraum vor der Auswahl eines der phasenverschobenen Signale des Verstärkers durch das Auswahlelement (23) zu versorgen.

7. Zähler/Teiler-Schaltung nach Anspruch 1, **dadurch gekennzeichnet, dass** der Steuerblock eine Reihe von Kippschaltungen (31; 34; 38) umfasst, die durch das Ausgangssignal (2Fdiv) des vorletzten Teilers durch zwei getaktet werden, und eine Anordnung aus Logikgattern umfasst, um die Steuersignale an den Auswahlblock auszugeben.

8. Zähler/Teiler-Schaltung nach Anspruch 1, **dadurch gekennzeichnet, dass** der Steuerblock einen nichtflüchtigen Speicher, beispielsweise einen Speicher des ROM-Typs, in den an bestimmten Positionen (m1 bis m8) mehrere binäre Wörter, wovon jedes den Zustand der ersten und der zweiten Steuersignale für jede bestimmte Teilungs-Halbperiode repräsentiert, eingetragen sind, und einen Zähler umfasst, der durch das Ausgangssignal des vorletzten Teilers durch zwei in der Weise getaktet wird, dass bei jedem Übergang des Zählers eine sukzessive Speicherposition in der ausgewählten zweiten Betriebsart adressiert wird oder eine bestimmte Speicherposition in der ausgewählten ersten Betriebsart beibehalten wird.

9. Zähler/Teiler-Schaltung nach einem der Ansprüche 1, 2 und 4, **dadurch gekennzeichnet, dass** der erste Zweig zwei phasenverschobene Signale (F2I, F2Ib) mit entgegengesetzter Phase empfängt, dass der zweite Zweig zwei weitere phasenverschobene Signale (F2Q, F2Qb) mit entgegengesetzter Phase empfängt und dass die Steuersignale so beschaffen sind, dass sie bei einer Phasenumschaltung zwischen den ausgewählten ersten und zweiten Signalen in dem Auswahlelement des Auswahlblocks die Auswahl des zweiten phasenverschobenen Signals in einem der jeweiligen Zweige in einer Periode erfolgt, die der Phasenumschaltung in dem Auswahlelement vorhergeht.

## Claims

1. Dual-modulus prescaler circuit particularly for a frequency synthesiser (1), said circuit dividing the frequency of at least one high frequency signal (Fs) by a factor N in a first selected mode and by a factor N+M in a second selected mode, said circuit including :
- several dividers-by-two (10, 12) of the asynchronous type, connected in series, one of the dividers being of the master-slave type (10) for receiving two input signals (Fs, Fsb) in phase opposition and supplying four signals phase shifted by 90° (F2l, F2lb, F2Q, F2Qb) in relation to each other,
- a phase selector unit (11) inserted between two of the dividers-by-two (10, 12a) for receiving the four phase shifted signals from the first master-slave divider and supplying one of the four selected phase shifted signals to the second divider, said selector unit including a first selection branch (21) receiving two first phase shifted signals (F2I, F2Ib), a second selection branch (22) receiving two second phase shifted signals (F2Q, F2Qb), and a selection element (23) connected to each branch, first control signals (S0, S1, S2) being supplied to the first and second branches, and to the selection element so that said selector unit supplies one of the four phase shifted signals (F2) selected at one output in a division period determined as a function of the selected mode,
- a control unit for supplying the first control signals to the selector unit, said control unit receiving an output signal (2Fdiv) from one of the dividers-by-two to clock operations in the control unit, and a signal for the mode selection,
the circuit being **characterised in that** the selector unit includes switching means (24, 26) controlled by second control signals (C1, C2) supplied by the control unit so as to disconnect the electric power supply of one of the selection branches in a period when the other branch is selected to supply one of the four phase shifted signals at the output of the selector unit.

2. Prescaler circuit according to claim 1, **characterised in that** each branch is formed of a differential amplifier (21, 22) for amplifying the received phase shifted signals, each amplifier being controlled by one of the first respective control signals (S1, S2) in order to supply at their output one of the two phase shifted signals.

3. Prescaler circuit according to claim 1, **characterised in that** the phase selector unit is inserted between the first and second dividers-by-two to receive the four signals from the first divider-by-two (10) which is of the master-slave type.

4. Prescaler circuit according to any of the preceding claims, **characterised in that** it includes six dividers-by-two (10, 12) of the asynchronous type for obtaining a frequency division by a factor N equal to 64 in a first mode, in which the first control signals (C1, C2, S0, S1, S2) do not change state at each division period determined such that only one of the four phase shifted signals is selected in the selector unit at each division period, and for obtaining a frequency division by a factor N+M equal to 64.5 in a second mode, in which, for each determined division period, certain first control signals change state to phase switch between a first phase shifted signal and a second phase shifted signal in phase delay of 90° from the first phase shifted signal so that the selector unit supplies at one output a different one of the four phase shifted signals at the end of each division period.

5. Prescaler circuit according to claim 2, **characterised in that** the switching means include a first switch (24) controlled by one of the second control signals (C1) for connecting or disconnecting the electric power supply to the differential amplifier (21) of the first amplifying branch, and a second switch (26) controlled by another of the second control signals (C2) for connecting or disconnecting the electric power supply to the differential amplifier (22) of the second amplifying branch.

6. Prescaler circuit according to claim 5, **characterised in that** the second control signals (C1, C2) are arranged to close the switch of one of the unused branches so as to power the corresponding amplifier a period of time preceding the selection of one of the phase shifted signals of said amplifier by the selection element (23).

7. Prescaler circuit according to claim 1, **characterised in that** the control unit includes a series of flip-flops (31; 34; 38) clocked in a synchronous manner by the output signal (2Fdiv) of the second to last divider-by-two, and an arrangement of logic gates for supplying control signals to the selector unit.

8. Prescaler circuit according to claim 1, **characterised in that** the control unit includes a non-volatile memory, for example a ROM type memory, in which several binary words are stored in determined locations (m1 to m8), each binary word representing the state of the first and second control signals for each determined half division period and a counter clocked by the output signal of the second to last divider-by-two so as to address a successive memory location at each transition of the counter in the second selected mode or to keep a determined memory location in the first selected mode.

9. Prescaler circuit according to any of claims 1, 2 and 4, **characterised in that** the first branch receives two phase shifted signals in phase opposition (F2I, F2Ib), **in that** the second branch receives two other phase shifted signals in phase opposition (F2Q, F2Qb), and **in that** the control signals are arranged such that, during phase switching between first and second phase shifted signals selected in the selection element of the selector unit, selection of the second phase shifted signal in one of the respective branches occurs in a period preceding phase switching in the selection element.
